# EUROPEAN PATENT APPLICATION

(11) **EP 1 840 943 A1**
(43) Date of publication of application: **03.10.2007**
(21) Application number: 05809699.1
(22) Date of filing: 24.11.2005
(51) Int. Cl.: H01L 21/027, G03F 9/00, G12B 5/00, H01L 21/68

(54) **MOBILE BODY SYSTEM, EXPOSURE APPARATUS, AND METHOD OF PRODUCING DEVICE**

(30) Priority: 25.11.2004 JP 2004340202
(71) Applicant: NIKON CORPORATION, Tokyo 100-8331 (JP)
(72) Inventor: YODA, Yasushi, c/o NIKON CORPORATION, Chiyoda-ku, Tokyo 1008331 (JP); SHIBAZAKI, Yuichi, c/o NIKON CORPORATION, Tokyo 1008331 (JP); ARAI, Dai, c/o NIKON CORPORATION, Tokyo 1008331 (JP)
(74) Representative: Viering, Jentschura & Partner
(86) International application number: PCT/JP2005/021512
(87) International publication number: WO 2006/057263

(57) **Abstract**

Stopper mechanisms (48A, 48B) keep a wafer table (WTB) and a measurement table (MTB) from moving closer than a predetermined distance, and the blocking by the stopper mechanisms can also be released by a drive mechanism (34A). Therefore, for example, in the case X-axis stators (81, 80) are driven independently, even if at least one of the two tables go out of control, the stopper mechanisms can keep the tables from coming into contact with each other, and for example, in the case the tables are to be in a state closer than the predetermined distance, by a release mechanism that releases the blocking of the stopper mechanisms, the tables can approach each other without the stopper mechanisms interfering.

## Description

The present invention relates to movable body systems, exposure apparatus, and device manufacturing methods, and more particularly to a movable body system that has two movable bodies which can be moved independently in a predetermined uniaxial direction, an exposure apparatus that is equipped with the movable body system, and a device manufacturing method in which a device pattern is transferred onto a substrate using the exposure apparatus.

Conventionally, in a lithography process for manufacturing electronic devices such as a semiconductor (an integrated circuit or the like), a liquid crystal display device or the like, a reduction projection exposure apparatus by a step-and-repeat method (the so-called stepper) that transfers a pattern of a mask (or a reticle) via a projection optical system onto each of a plurality of shot areas on a photosensitive object such as a wafer, a glass plate or the like on which a resist (a photosensitive agent) is coated (hereinafter referred to as a "wafer"), a projection exposure apparatus by a step-and-scan method (the so-called scanning stepper (also called a scanner)) and the like are mainly used.

With these types of projection exposure apparatus, a higher resolving power (resolution) is required year by year to cope with finer patterns due to higher integration of integrated circuits. This gradually brought forward a situation where exposure light requires a shorter wavelength and the projection optical system requires an increase in numerical aperture (NA) (a larger NA). However, although such shorter wavelength of the exposure light and increase in the numerical aperture improve the resolution of the projection exposure apparatus, they also cause the depth of focus to decrease. Further, it is presumed that the wavelength will become much shorter in the future, and if the situation continues, the risk occurred of the depth of focus becoming so small that focus margin shortage would occur during the exposure operation.

Therefore, as a method of substantially shortening the exposure wavelength while increasing (widening) the depth of focus when compared with the depth of focus in the air, the exposure apparatus that uses the liquid immersion method is recently beginning to gathering attention. As such an exposure apparatus using the liquid immersion method, the apparatus that performs exposure in a state where the space between the lower surface of the projection optical system and the wafer surface is locally filled with liquid such as water or an organic solvent is known (for example, refer to Patent Document 1 below). According to the exposure apparatus of Patent Document 1, the resolution can be improved by making use of the fact that the wavelength of the exposure light in the liquid becomes 1/n of the wavelength in the air (n is the refractive index of the liquid which is normally around 1.2 to 1.6), and the depth of focus can be also substantially increased n times when compared with the case where the same resolution is obtained by a projection optical system (supposing that such a projection optical system can be made) that does not employ the immersion method, that is, the depth of focus can be substantially increased n times than in the air.

Further, proposals are recently made of an exposure apparatus that is equipped with two wafer stages, or of an exposure apparatus equipped with a stage (a measurement stage), which can be driven within a two-dimensional plane independently from a wafer stage (a substrate stage), and on which a measurement instrument used for measurement is arranged (for example, refer to Patent Documents 2, 3 and the like).

However, in the exposure apparatus above, because the exposure apparatus is equipped with two stages, in the case when both stages cannot be appropriately controlled, that is, in the case both stages go out of control, the stages may bump into each other. When such a situation occurs, the possibility is high that both of the stages will naturally be damaged, and a risk also occurs of the control performance including position setting of the stage or the like being degraded due to the damage.
Patent Document 1: the pamphlet of International Publication No. WO99/49504,
Patent Document 2: Kokai (Japanese Unexamined Patent Application Publication) No. 11-135400, and
Patent Document 3: Kokai (Japanese Unexamined Patent Application Publication) No. 03-211812.

The present invention has been made in consideration of the situation described above, and according to a first aspect of the present invention, there is provided a first movable body system that has two movable bodies that can be moved independently in a predetermined uniaxial direction, the system comprising: a stopper mechanism that blocks the two movable bodies from moving closer to each other than a predetermined distance; a release mechanism that releases the blocking by the stopper mechanism so that the two movable bodies are allowed to move closer than the predetermined distance.

According to the system, the stopper mechanism blocks the two movable bodies from moving closer to each other than a predetermined distance, and when the release mechanism releases the blocking by the stopper mechanism, the two movable bodies can move closer to each other than the predetermined distance. Therefore, for example, in the case the movable bodies are driven independently, even if at least one of the two movable bodies go out of control, the stopper mechanism can prevent the movable bodies from coming into contact with each other. Furthermore, on the other hand, for example, in the case the movable bodies are to be in a state closer to each other than the predetermined distance, by the release mechanism releasing the blocking of the stopper mechanism, both of the movable bodies can move closer to each other without the stopper mechanism interfering.

According to a second aspect of the present invention, there is provided a first exposure apparatus that exposes a substrate and forms a pattern on the substrate, the apparatus comprising: a first movable body system of the present invention that holds the substrate with at least one of the two movable bodies; and a control unit that controls the operation of the release mechanism.

According to the apparatus, because the apparatus is equipped with the movable body system of the present invention in which the stopper mechanism prevents the two movable bodies from bumping into each other and the release mechanism makes it possible for the two movable bodies to move closer to each other than a predetermined distance without the stopper mechanism interfering, even if one of the movable bodies go out of control when the substrate held by at least one of the two movable bodies is exposed, the stopper mechanism can prevent the two movable bodies from coming into contact and the damage or the like that may occur. As a consequence, controllability of the movable body can be maintained highly, which makes it possible to maintain high exposure accuracy. Further, the release unit releases the blocking of the stopper mechanism which allows the two movable bodies to move closer to each other, therefore, when the two movable bodies need to move closer to each other in an operation related to exposure or the like, it becomes possible to move the two bodies closer to each other without the stopper mechanism interfering.

According to a third aspect of the present invention, there is provided a second exposure apparatus that supplies liquid in the space between an optical system and a substrate and exposes the substrate with an energy beam via the optical system and the liquid, the apparatus comprising: the first movable body system of the present invention in which liquid immersion feasible areas where the liquid can be held are formed in the space between each of the two movable bodies and the optical system, and the substrate is also held in at least one of the two movable bodies; and a control unit that controls the operation of the two movable bodies while maintaining a state in which the two movable bodies are in contact or a predetermined state in which the two movable bodies are closer than a predetermined distance, so as to move the liquid from the liquid immersion feasible area of one of the movable bodies to the liquid immersion feasible area of the other movable body.

According to the apparatus, on exposure operation, the stopper mechanism that constitutes the movable body system is kept in a state where the stopper mechanism can prevent the two movable bodies from approaching each other just in case the movable bodies go out of control. Meanwhile, when the liquid immersion area of the liquid is to be moved from one of the liquid immersion feasible areas to the other liquid immersion feasible area in the two movable bodies, the operation of the two movable bodies is controlled while maintaining a contact state of the two movable bodies or a state where the two movable bodies are in a predetermined state closer than a predetermined distance, in a state where the release unit releases the blocking by the stopper mechanism. Accordingly, in the case of transition from a state in which the liquid immersion feasible area is formed on one of the movable bodies to a state in which the liquid immersion feasible area is formed on the other movable body, a series of operations of; stopping the supply of liquid → moving the two movable bodies → starting the supply of liquid again, do not have to be performed. Therefore, exposure accuracy can be maintained at a high level, and also the speed of movement of the two movable bodies under the optical system can be increased, which makes it possible to achieve high throughput.

According to a fourth aspect of the present invention, there is provided a second movable body system, comprising: two movable bodies that can move independently in a predetermined uniaxial direction; a change unit that can change an approachable distance between the two movable bodies in the predetermined uniaxial direction among a plurality of distances which are set in advance.

According to a fifth aspect of the present invention, there is provided a third exposure apparatus that exposes a substrate and forms a pattern on the substrate, the apparatus comprising: the second movable body system that holds the substrate in at least one of the two movable bodies; and a control unit that controls the operation of the change unit.

Further, in a lithography process, by transferring a device pattern on a substrate using the first to third exposure apparatus of the present invention, productivity of high integration microdevices can be improved. Accordingly, further from another aspect, it can also be said that the present invention is a device manufacturing method that uses one of the first to third exposure apparatus of the present invention.
FIG.1 is a schematic view of an exposure apparatus according to an embodiment.
FIG.2 is a planar view of a stage unit FIG. 1.
FIGS.3A to 3C are views for describing a detachable member arranged on a measurement table.
FIG.4 is a perspective view that shows a +X side edge section of X-axis stators 80 and 81.
FIG.5 is a view for describing an arrangement of a shock absorber.
FIGS.6A to 6D are views for describing an operation of a stopper mechanism.
FIG.7 is a planar view that shows a state of X-axis stators closest to each other.
FIG.8 is a block diagram that shows a main configuration of a control system related to the embodiment.
FIG.9 is a planar view that shows a state where the measurement stage is just under a projection optical system.
FIGS.10A and 10B are views of a modified example (No. 1) of the stopper mechanism.
FIGS. 11A to 10D are views of a modified example (No.2) of the stopper mechanism.
FIGS. 12A and 12B are views for describing a relative movement of X-axis stators 80 and 81 (a wafer table WTB and a measurement table MTB) in the X-axis direction in a state where the shock absorber and a shutter are in contact.
FIG.13 is a flowchart for explaining a device manufacturing method according to the present invention.
FIG.14 is a flowchart that shows a specific example of step 204 in FIG. 13.

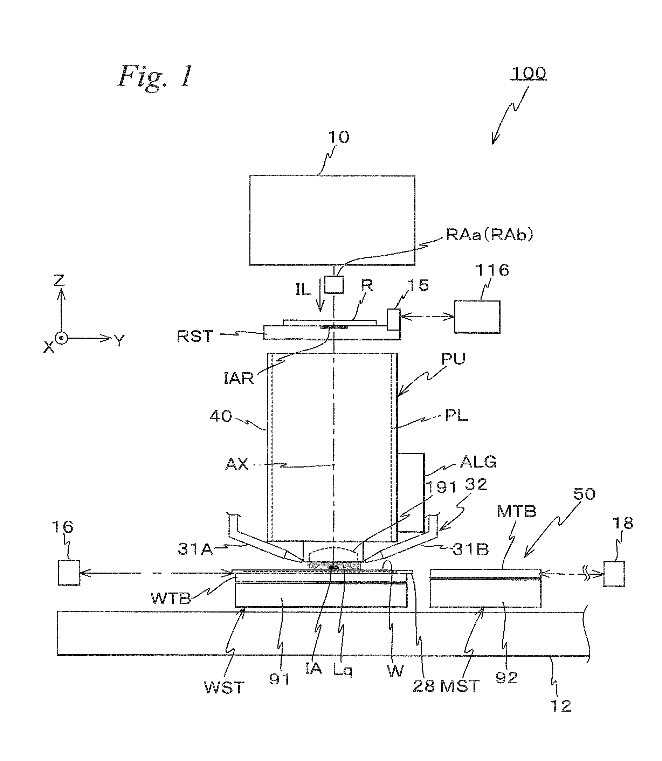

An embodiment of the present invention will be described below, based on FIGS.1 to 9.

FIG. 1 shows the entire configuration of an exposure apparatus 100 related to the embodiment. Exposure apparatus 100 is a scanning exposure apparatus by a step-and-scan method, that is, the so-called scanner.

Exposure apparatus 100 includes an illumination system 10, a reticle stage RST that holds a reticle R which is illuminated by an exposure illumination light (hereinafter also referred to as an "illumination light" or "exposure light") IL from illumination system 10, a projection unit PU including a projection optical system PL which projects illumination light IL emitted from reticle R on a wafer W, a stage unit 50 that has a wafer stage WST and a measurement stage MST, a control system for these parts and the like. Wafer W is to be mounted on wafer stage WST.

As is disclosed in, for example, Kokai (Japanese Unexamined Patent Application Publication) No.2001-313250 and its corresponding U.S. Patent Application Publication No.2003/0025890 description or the like, illumination system 10 is configured including a light source and an illuminance uniformity optical system, which includes an optical integrator and the like. Illumination system 10 also includes a beam splitter, a relay lens, a variable ND filter, a reticle blind, and the like (none of which are shown). In illumination system 10, illumination light (exposure light) IL illuminates a slit-shaped illumination area set by the reticle blind on reticle R with a substantially uniform illuminance. In this case, for example, an ArF excimer laser beam (wavelength: 193 nm) is used as illumination light IL. Further, as the optical integrator, a fly-eye lens, a rod integrator (an internal reflection type integrator), a diffractive optical element or the like can be used. As long as the national laws in designated states or elected states, to which this international application is applied, permit, the above disclosure of the U.S. Patent application publication description is incorporated herein by reference.

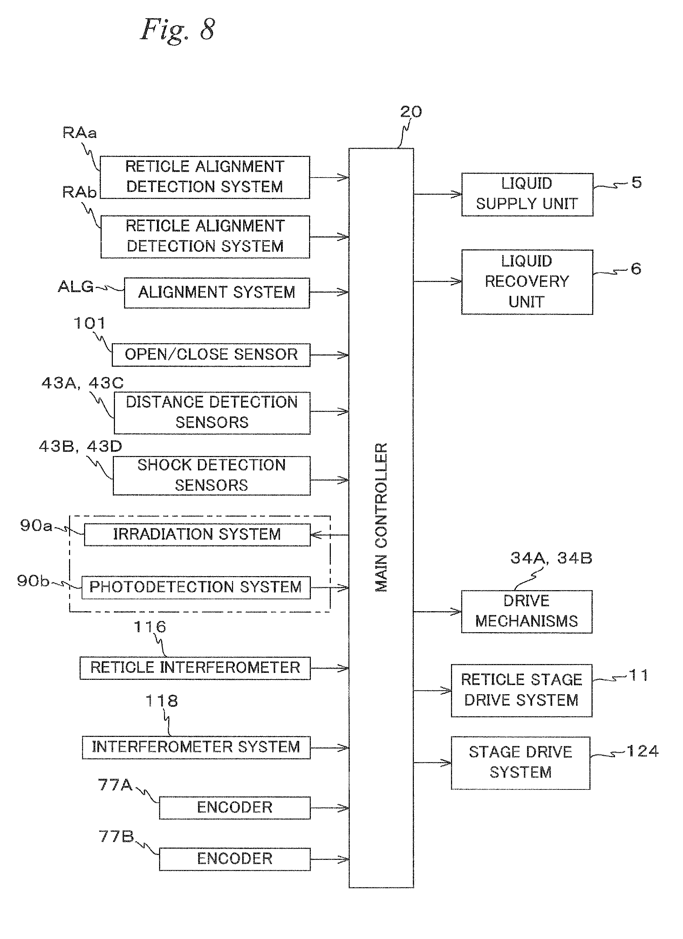

On reticle stage RST, reticle R that has a circuit pattern or the like formed on the pattern surface (the lower surface in FIG. 1) is fixed, for example, by vacuum suction. Reticle stage RST can be driven finely in an XY plane, for example, by a reticle stage drive section 11 (not shown in FIG. 1, refer to FIG. 8) which includes a linear motor or the like, and can also be driven in a predetermined scanning direction (in this case, a Y-axis direction which is the lateral direction in FIG. 1) at a designated scanning speed.

The position of reticle stage RST (including rotation around a Z-axis) within a stage movement plane is constantly detected by a reticle laser interferometer (hereinafter referred to as a "reticle interferometer") 116, for example, at a resolution of around 0.5 to 1 nm, via a movable mirror 15 (a Y movable mirror that has a reflection surface orthogonal to the Y-axis direction and an X movable mirror that has a reflection surface orthogonal to an X-axis direction are actually arranged). Measurement values of reticle interferometer 116 is sent to a main controller 20 (not shown in FIG. 1, refer to FIG. 8), and based on the measurement values of reticle interferometer 116, main controller 20 computes the position of reticles stage RST in the X-axis direction, the Y-axis direction, and a θz direction (the rotational direction around the Z-axis) and also controls the position (and speed) of reticle stage RST by controlling reticle stage drive section 11 based on the computation results. Instead of movable mirror 15, the edge surface of reticle stage RST can be mirror-polished so that a reflection surface (corresponding to the reflection surface of movable mirror 15) is formed.

Above reticle R, a pair of reticle alignment detection systems RAa and RAb consisting of TTR (Through The Reticle) alignment systems that use light of the exposure wavelength so as to simultaneously observe a pair of reticle alignment marks and a pair of fiducial marks on measurement stage MST that correspond to the reticle alignment marks (hereinafter referred to as "a first fiducial mark") via projection optical system PL is arranged spaced a predetermined distance apart in the X-axis direction. As these reticle alignment detection systems RAa and RAb, a system is used that has a configuration similar to the one disclosed in, for example, Kokai (Japanese Unexamined Patent Application Publication) No. 7-176468 and the corresponding U.S. Patent No. 5,646,413 and the like. As long as the national laws in designated states (or elected states), on which this international application is applied, permit, the above disclosure of the U.S. Patent is incorporated herein by reference.

Projection unit PU is arranged below reticle stage RST in FIG. 1. Projection unit PU is configured including a barrel 40, and projection optical system PL consisting of a plurality of optical elements held in a predetermined positional relation within barrel 40. As projection optical system PL, a dioptric system is used consisting of a plurality of lenses (lens elements) that share an optical axis AX in the Z-axis direction. Projection optical system PL is, for example, a both-side telecentric dioptric system that has a predetermined projection magnification (such as one-quarter or one-fifth times) is used. Therefore, when illumination light IL from illumination system 10 illuminates an illumination area IAR on reticle R, by illumination light IL that has passed through reticle R, a reduced image of the circuit pattern within illumination area IAR of reticle R (a partial reduced image of the circuit pattern) is formed on an area (hereinafter also referred to as an "exposure area") IA conjugate to illumination area IAR on wafer W whose surface is coated with a resist (a photosensitive agent) via projection optical system PL (projection unit PU).

In exposure apparatus 100 of the embodiment, because exposure to which the liquid immersion method is applied is performed as it will be described later on, the numerical aperture NA substantially increases which makes the opening on the reticle side larger. Therefore, in a dioptric system consisting only of lenses, it becomes difficult to satisfy the Petzval condition, which tends to lead to an increase in the size of the projection optical system. In order to prevent such an increase in the size of the projection optical system, a catodioptric system that includes mirrors and lenses may also be used.

Further, in exposure apparatus 100 of the embodiment, because exposure with the liquid immersion method applied is performed, a liquid supply nozzle 31A and a liquid recovery nozzle 31B that make up a liquid immersion unit 32 are arranged in the vicinity of a lens 191, which serves as an optical element (hereinafter also referred to as a 'tip lens') that constitutes projection optical system PL closest to the image plane side (the wafer W side).

Liquid supply nozzle 31A connects to the other end of a supply pipe (not shown) that has one end connected to a liquid supply unit 5 (not shown in FIG. 1, refer to FIG. 8) , and liquid recovery nozzle 31B connects to the other end of a recovery pipe (not shown) that has one end connected to a liquid recovery unit 6 (not shown in FIG. 1, refer to FIG. 8).

Liquid supply unit 5 includes parts such as a liquid tank, a compression pump, and temperature control unit, and a valve for controlling the supply/stop of liquid with respect to the supply pipe and the like. As the valve, a flow control valve is preferably used, for example, so that not only the supply/stop of liquid but also the flow adjustment can be performed. The temperature control unit adjusts the temperature of the liquid inside the liquid tank so that is about the same temperature as the temperature within a chamber (not shown) where the exposure apparatus is housed. Incidentally, the liquid tank, the compression pump, the temperature adjustment unit, the valves and the like do not all have to be equipped in exposure apparatus 100, and at least a part of such parts may be substituted by the equipment available in the factory where exposure apparatus 100 is installed.

Liquid recovery unit 6 consists of parts including a liquid tank and a suction pump, and a valve for controlling the supply/stop of liquid via the recovery pipe and the like. As the valve, a flow control valve is preferably used corresponding to the valve used in the liquid supply unit 5. Incidentally, the tank for recovering the liquid, the suction pump, the valves and the like do not all have to be equipped in exposure apparatus 100, and at least a part of such parts may be substituted by the equipment available in the factory where exposure apparatus 100 is installed.

As the liquid referred to above, ultra pure water (hereinafter, ultra pure water will simply be referred to as 'water' besides the case when specifying is necessary) that transmits the ArF excimer laser beam (light with a wavelength of 193 nm) is to be used. Ultra pure water can be obtained in large quantities at a semiconductor manufacturing plant or the like, and using ultra pure water also has an advantage of having no adverse effect on the photoresist on the wafer or to the optical lenses.

Refractive index n of the water to the ArF excimer laser beam is approximately 1.44. In the water, the wavelength of illumination light IL is shorted to approximately 193 nm x 1/n = 134 nm.

Liquid supply unit 5 and liquid recovery unit 6 both have a controller, and each of the controllers operate under the control of main controller 20 (refer to FIG. 8). According to instructions from main controller 20, the controller of liquid supply unit 5 opens the valve connected to the supply pipe to a predetermined degree so as to supply the water in the space between tip lens 191 and wafer W via liquid supply nozzle 31A. Further, when the water is supplied, according to instructions from main controller 20, the controller of liquid recovery unit 6 opens the valve connected to the recovery pipe to a predetermined degree so that the water is recovered into liquid recovery unit 6 from the space between tip lens 191 and wafer W via liquid recovery nozzle 31B. During the supply and recovery operations, main controller 20 gives orders to liquid supply unit 5 and liquid recovery unit 6 so that the amount of water supplied to the space between tip lens 191 and wafer W from liquid supply nozzle 31A constantly equals the amount of water recovered via liquid recovery nozzle 31B. Accordingly, a constant amount of water Lq (refer to FIG. 1) is held in the space between tip lens 191 and wafer W. In this case, water Lq held or retained in the space between tip lens 191 and wafer W is constantly replaced.

As is obvious from the description above, immersion unit 32 of the embodiment is a local immersion unit that includes parts such as liquid supply unit 5, liquid recovery unit 6, the supply pipe, the recovery pipe, liquid supply nozzle 31A, liquid recovery nozzle 31B and the like.

In the case measurement stage MST is positioned below projection unit PU, it is possible to fill in the space between measurement table MTB and tip lens 191 with the water as in the case described above.

In the description above, only one liquid supply nozzle and one liquid recovery nozzle were arranged in order to simplify the description, however, the present invention is not limited to this, and a configuration that has many nozzles as is disclosed in, for example, the pamphlet of International Publication No. WO99/49504 can be employed. The point is that any configuration can be employed as long as the liquid can be supplied in the space between optical element (tip lens) 191 that constitutes projection optical system PL at the lowest end and wafer W. The liquid immersion mechanism disclosed in, for example, the pamphlet of International Publication WO2004/053955, or the liquid immersion mechanism disclosed in European Patent Application Publication No. 1420298 can also be applied to the exposure apparatus in the embodiment. As long as the national laws in designated states (or elected states), to which this international application is applied, permit, the above disclosures of the pamphlet of International Publication and the European Patent Application Publication are incorporated herein by reference.

Stage unit 50 includes a base platform 12, a wafer stage WST and a measurement stage MST arranged above the upper surface of base platform 12, an interferometer system 118 (refer to FIG. 8) that includes Y-axis interferometers 16 and 18 for measuring the positions of stage WST and stage MST, and a stage drive system 124 (refer to FIG. 8) for driving stages WST and MST.

On the bottom surface of wafer stage WST and measurement stage MST, non-contact bearings such as vacuum preload gas statistic bearings (not shown) (hereinafter referred to as "air pads") are arranged at a plurality of places, and by static pressure of pressurized air blown out from the air pads toward the upper surface of base platform 12, wafer stage WST and measurement stage MST are supported by levitation in a non-contact manner via a clearance of around several µm above the upper surface of base platform 12. Further, each of the stages WST and MST are configured so that they can be driven independently in a two-dimensional direction in the X-axis direction (a lateral direction of the page surface in FIG. 1) and the Y-axis direction (an orthogonal direction to the page surface of FIG. 1) by stage drive system 124.

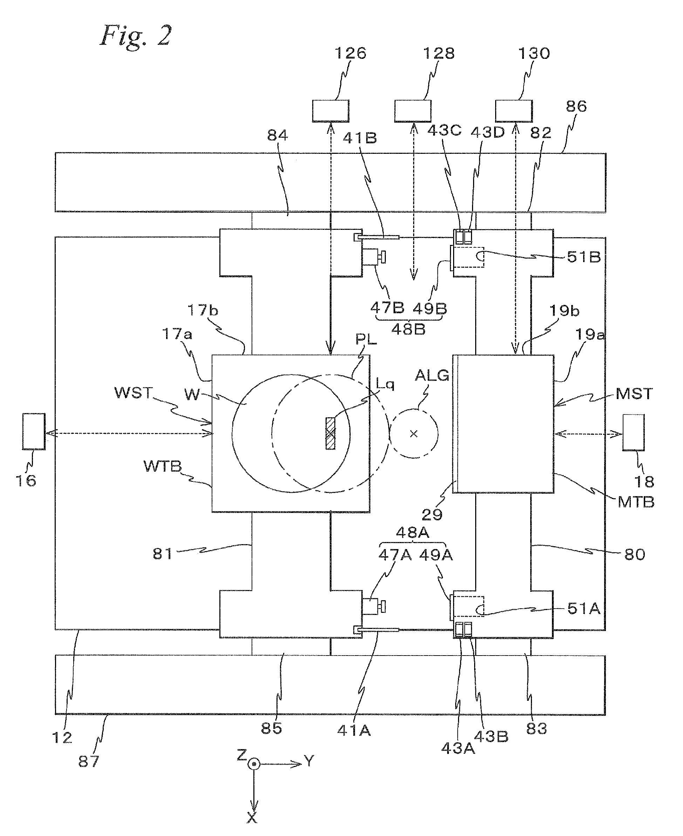

On base platform 12, as is shown in the planar view in FIG. 2, a pair of Y-axis stators 86 and 87 extending in the Y-axis direction is placed, spaced at a predetermined distance in the X-axis direction. Theses stators 86 and 87 are configured, for example, of a magnetic pole unit that incorporates a permanent magnet group consisting of a plurality of sets of N-pole magnets and S-pole magnets placed alternately at a predetermined distance along the Y-axis direction. To these Y-axis stators 86 and 87, Y-axis movers 82 and 84, and 83 and 85, which are made up of two movers each, are arranged in a state engaged with the corresponding Y-axis stators 86 and 87 in a non-contact manner. More specifically, the total of four Y-axis movers 82, 84, 83, and 85 are in a state where the movers are inserted into an inner space of Y-axis stator 86 or 87 that has a shape of the letter U in an XZ section, and are supported by levitation via a clearance of for example, around several µm, via air pads (not shown) with respect the corresponding Y-axis stator 86 or 87. Y-axis movers 82, 84, 83, and 85 are each configured, for example, of an armature unit that incorporates armature coils placed at a predetermined distance align the Y-axis direction. That is, in the embodiment, Y-axis mover 82 consisting of an armature unit and Y-axis stator 86 consisting of a magnetic pole unit, and Y-axis mover 84 and Y-axis stator 86 respectively constitute a moving coil type Y-axis linear motor. Similarly, Y-axis mover 83 and Y-axis stator 87, and Y-axis mover 85 and Y-axis stator 87 respectively constitute a moving coil type Y-axis linear motor. In the description below, the four Y-axis linear motors described above will be appropriately referred to as Y-axis linear motor 82, Y-axis linear motor 84, Y-axis linear motor 83, and Y-axis linear motor 85, using the same reference numerals as each of the Y-axis movers 82, 84, 83, and 85.

Of the four Y-axis linear motors described above, movers 82 and 83 of two of the Y-axis linear motors 82 and 83 are fixed to one end and the other end in the longitudinal direction of an X-axis stator 80 extending in the X-axis direction. Further, movers 84 and 85 of the remaining Y-axis linear motors 84 and 85 are fixed to one end and the other end in the longitudinal direction of an X-axis stator 81 extending in the X-axis direction. Accordingly, X-axis stators 80 and 81 are each driven along the Y-axis by the pair of the Y-axis linear motors 82 and 83, and the pair of the Y-axis linear motors 84 and 85.

X-axis stators 80 and 81 are each configured, for example, by an armature unit that incorporates armature coils installed along the X-axis direction at a predetermined distance.

One of the X-axis stators 81 is arranged in a state inserted into an opening (not shown) formed in an X movable body 91 (not shown in FIG. 2, refer to FIG. 1) that constitutes wafer stage WST. Inside the opening of X movable body 91 described above, for example, a magnetic pole unit is arranged that has a group of permanent magnets consisting of a plurality of sets of an N-pole magnet and an S-pole magnet placed alternately at a predetermined distance along the X-axis direction. And, the magnetic pole unit and the X-axis stator 81 constitute a moving magnet type X-axis linear motor that drives movable body 91 in the X-axis direction. Similarly, the other X-axis stator 80 is arranged in a state inserted into an opening (not shown) formed in an X movable body 92 (not shown in FIG. 2, refer to FIG. 1) that constitutes measurement stage MST. Inside the opening of X movable body 92 described above, a magnetic pole unit similar to the one arranged on the wafer stage WST side is arranged. And, the magnetic pole unit and the X-axis stator 80 constitute a moving magnet type X-axis linear motor that drives measurement stage MST in the X-axis direction. Hereinafter, the X-axis linear motors will be appropriately referred to as an X-axis linear motor 81 and an X-axis linear motor 80, using the same reference numerals as the stators configuring the X-axis linear motors, X-axis stator 81 and X-axis stator 80.

In the embodiment, each of the linear motors that constitute stage drive system 124 operates under the control of main controller 20 shown in FIG. 8. Each linear motor is not limited only to either the moving magnet type X-axis linear motor or the moving coil type X-axis linear motor, and the type of motor can be appropriately selected when necessary.

By slightly changing the thrust generated in each of the pair of Y-axis linear motors 84 and 85 (or 82 and 83), yawing control of wafer stage WST or measurement stage MST becomes possible.

Wafer stage WST is installed via X movable body 91 and a Z leveling mechanism (not shown) (such as a voice coil motor) on X movable body 91, and includes a wafer table WTB which is finely driven relatively in the Z-axis direction, a rotational direction around the X-axis (θx direction), and a rotational direction around the Y-axis (θy direction) with respect to X movable body 91.

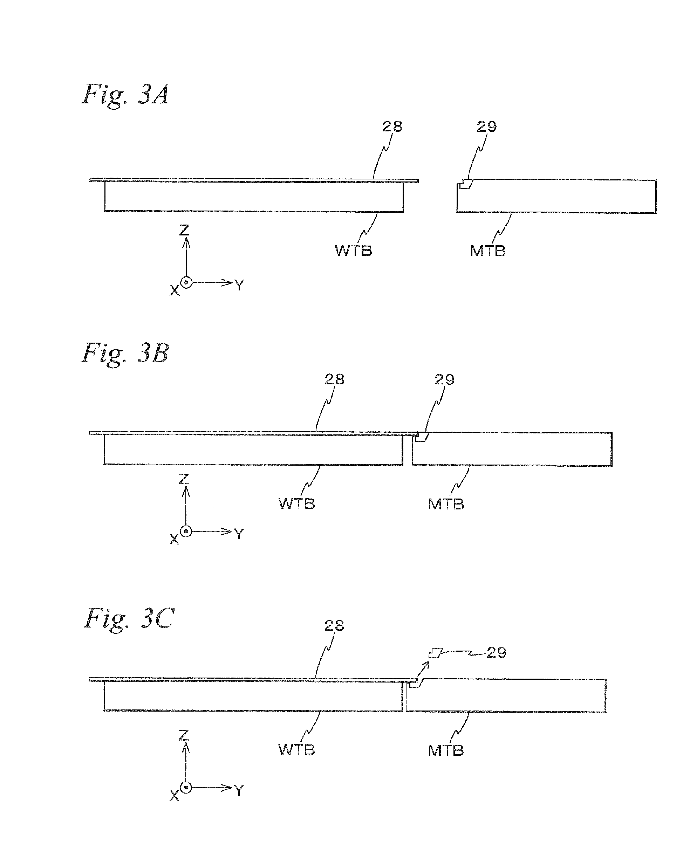

On wafer table WTB, a wafer holder (not shown) is arranged that holds wafer W by vacuum suction or the like. Further, on the upper surface of wafer table WTB, an auxiliary plate (water repellent plate) 28 (refer to FIGS. 1 and 3) is arranged flush with the wafer mounted on the wafer holder, having a rectangular shape as a whole and also having a circular opening slightly larger than the wafer holder in the center. The liquid repellent (water repellent) surface of auxiliary plate (water repellent plate) 28 provides poor protection against light in the deep ultraviolet region or the vacuum ultraviolet region, and the liquid repellent (water repellent) performance deteriorates due to irradiation of the exposure light. Further, water stains (water marks) of the liquid may be generated on the upper surface of auxiliary plate (water repellent plate) 28. Accordingly, auxiliary plate (water repellent plate) 28 is made easily detachable (exchangeable) with respect to wafer table WTB. In order to fix the auxiliary plate (water repellent plate), various methods such as the vacuum suction method or the electrostatic suction method can be employed.

On the -Y edge surface of wafer table WTB, a reflection surface 17a is formed by mirror polishing as is shown in FIG. 2, and on the -X edge surface a reflection surface 17b is formed by mirror polishing in a similar manner. On these reflection surfaces, interferometer beams are projected from interferometers (Y-axis interferometer 16 regarding the Y-axis direction, and a plurality of X-axis interferometers 126 and 128 regarding the X-axis direction) that constitute interferometer system 118 (refer to FIG. 8), and by each interferometer receiving the reflection beams, displacement is measured of each reflection surface from a reference surface (normally, a fixed mirror is arranged on the side surface of projection unit PU or the side surface of an alignment system ALG, which serves as the reference surface), and according to this measurement, the two-dimensional position of wafer stage WST is measured. Incidentally, although it is not shown in FIG. 2, in the case the measurement beam from X-axis interferometer is not incident on the reflection surface, the position of wafer table WTB is to be measured by an encoder 77A (refer to FIG. 8).

Measurement stage MST includes X movable body 92, and measurement table MTB installed on X movable body 92. Measurement table MTB is also installed on X movable body 92 via the Z leveling mechanism (not shown). Incidentally, a configuration can also be employed in which measurement table MTB is fixed to X movable body 92 and X movable body 92 is drivable in directions of six degrees of freedom.

On measurement table MTB (and X movable body 92), various measurement members are arranged. As such measurement members, for example, a fiducial mark plate on which a plurality of fiducial marks are formed or a sensor that receives illumination light IL via projection optical system PL such as the ones disclosed in, for example, Kokai (Japanese Unexamined Patent Application Publication) No. 5-21314, and the corresponding U. S. Patent No. 5,243,195 are included. As the sensor, an illumination monitor having a photodetection section of a predetermined area for receiving illumination light IL on the image plane of projection optical system PL whose details are disclosed in Kokai (Japanese Unexamined Patent Application Publication) No. 11-16816, and the corresponding U.S. Patent Application Publication No. 2002/0061469, an uneven illuminance measuring sensor, which has a pinhole-shaped light-receiving section that receives illumination light IL on the image plane of projection optical system PL whose details are disclosed in Kokai (Japanese Unexamined Patent Application Publication) No. 57-117238 and the corresponding U. S. Patent No. 4,465,368, or an aerial image measuring instrument that measures the light intensity of the aerial image (projected image) of the pattern projected by projection optical system PL whose details are disclosed in Kokai (Japanese Unexamined Patent Application Publication) No. 2002-14005, and the corresponding U.S. Patent Application Publication No. 2002/0041377 can be employed. As long as the national laws in designated states or elected states, to which this international application is applied, permit, the above disclosures of the U. S. Patent and the U. S. Patent application publications are incorporated herein by reference.

In the embodiment, in response to the liquid immersion exposure performed in which wafer W is exposed by exposure light (illumination light) IL via projection optical system PL and water, the illumination monitor, the irregular illuminance measuring sensor, and the aerial image measuring instrument above used for measurement using illumination light IL are to receive illumination light IL via projection optical system PL and the water. Further, only a part of each sensor, such as the optical system, can be arranged on measurement table MTB (and X movable body 92), or the whole sensor can be disposed on measurement table MTB (and X movable body 92).

As is shown in FIGS. 2 and 3A, on the -Y side edge section of measurement table MTB, a detachable member 29 extending in the X-axis direction is arranged. Detachable member 29 is made, for example, of a Teflon (trademark) resin, and is fixed to measurement table MTB via a permanent magnet (not shown) or the like. In the case detachable member 29 receives a shock from the Y-axis direction (force from bumping into water repellent plate 28) as is shown in FIG. 3B, detachable member 29 can be detached from measurement table MTB as is shown in FIG. 3C.

On the +Y edge surface and -X edge surface of measurement table MTB, reflection surfaces 19a and 19b are formed (refer to FIG. 2) as in the ones described in wafer table WTB. On these reflection surfaces, interferometer beams are projected from interferometers (Y-axis interferometer 18 regarding the Y-axis direction, and a plurality of X-axis interferometers 126, 128, or 130 regarding the X-axis direction) that constitute interferometer system 118 (refer to FIG. 8), and by each interferometer receiving the reflection beams, displacement is measured of each reflection surface from a reference surface (normally, a fixed mirror is arranged on the side surface of projection unit PU or the side surface of alignment systemALG, which serves as the reference surface), and according to this measurement, the two-dimensional position of measurement stage MST is measured. Incidentally, although it is not shown in FIG. 2, in the case the measurement beam from X-axis interferometer is not incident on the reflection surface, the position of measurement table MTB is to be measured by an encoder 77B (refer to FIG. 8).

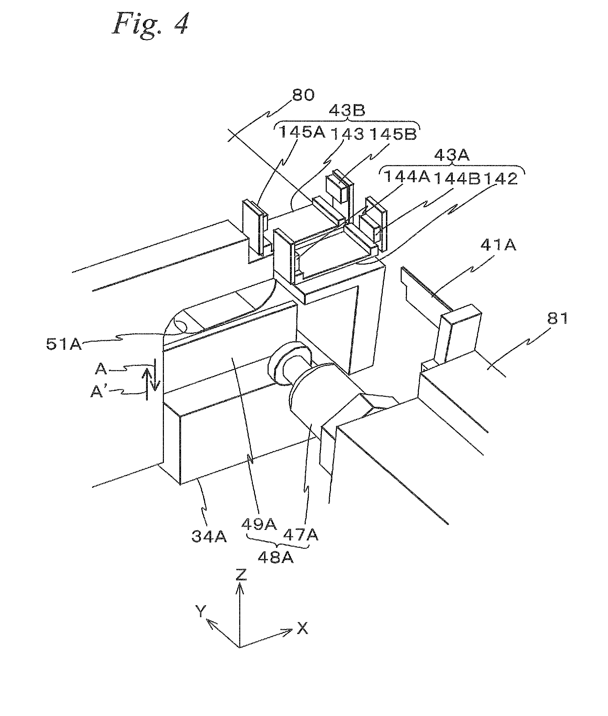

In X-axis stator 81 and X-axis stator 80 stopper mechanisms 48A and 48B are arranged, as is shown in FIG. 2 and FIG. 4, which is a perspective view of the vicinity of X-axis stators 80 and 81. One of the stopper mechanisms 48A includes a shock absorber 47A arranged in one of the X-axis stators 81 and a shutter 49A arranged in the other X-axis stator 80 at a position (on the +Y side) facing shock absorber 47A. In X-axis stator 80 at a position facing shock absorber 47A, an opening 51A is formed.

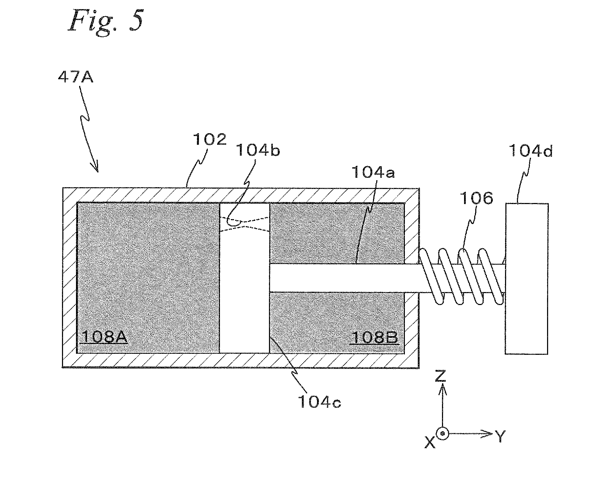

Shock absorber 47A consists of an oil damper, and as is shown in a sectional view in FIG. 5, includes a cylinder 102 of a hollow cylindrical shape (a circular sectional shape), a piston 104c of a solid cylindrical shape arranged inside cylinder 102, a piston rod 104a connecting to piston 104c, and a compression spring 106 arranged in the outer periphery section of piston rod 104a and clamped between the edge surface of cylinder 102 and a head section 104d of piston rod 104a. The inside of cylinder 102 is partitioned into a first chamber 108A and a second chamber 108B by piston 104c, and the first chamber 108A is in communication with the second chamber 108B via an orifice 104b arranged in piston 104c. In the inside of the first chamber 108A and the second chamber 108B, operating oil is inserted.

As is shown in FIG. 4, shutter 49A is arranged on the -Y side of opening 51A formed in X-axis stator 80, and shutter 49A is to be driven in directions indicated by the arrows A and A' (the Z-axis direction) by a drive mechanism 34A, which is configured including an air cylinder or the like. Accordingly, opening 51A can be in an open state or a closed state with shutter 49A. The opened/closed state of shutter 49A is detected using an open/close sensor (not shown in FIG. 4, refer to FIG. 8) 101 arranged in the vicinity of shutter 49A, and the detection results are sent to main controller 20.

The other stopper mechanism 48B also has a configuration similar to stopper mechanism 48A. More specifically, as is shown in FIG. 2, stopper mechanism 48B includes a shock absorber 47B arranged in the vicinity of the -X edge section of one of the X-axis stators 81 and a shutter 49B arranged in the other X-axis stator 80 at a position facing shock absorber 47B. Further, on the +Y side section of shutter 49B of X-axis stator 80, an opening 51B is formed.

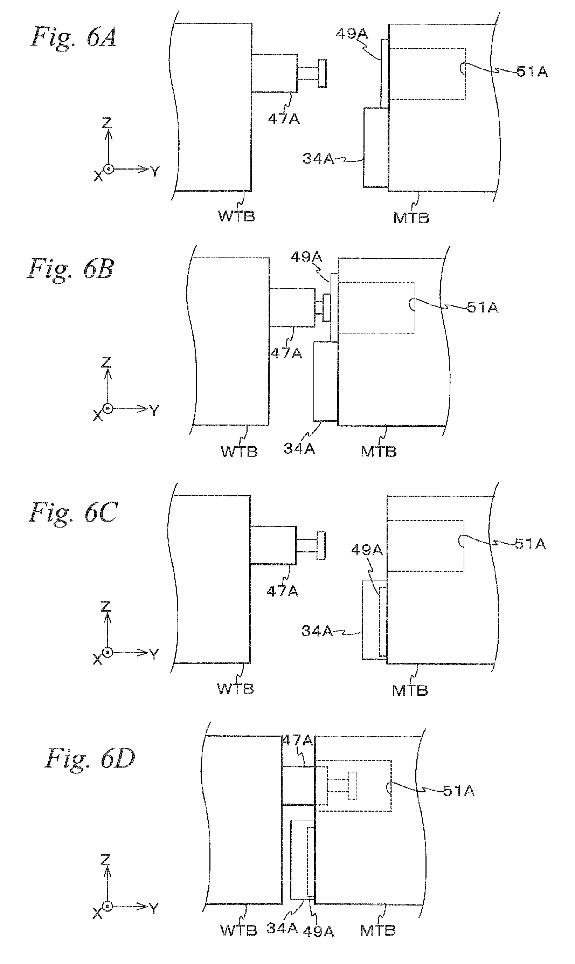

The operation of stopper mechanisms 48A and 48B will now be described, based on FIGS. 6A to 6D, which show enlarged views of a neighboring area of one of the stopper mechanisms, 48A.

As is shown in FIG. 6A, in the case shutter 49A is in a state of closing opening 51A, even when X-axis stator 81 and X-axis stator 80 draw close as is shown in FIG. 6B, X-axis stator 81 and X-axis stator 80 cannot move closer together due to shock absorber 47A and shutter 49A coming into contact. In this case, as is shown in FIG. 6B, the configuration is employed in which wafer table WTB and measurement table MTB do not come into contact even when piston 104c of shock absorber 47A moves furthest to the -Y side (that is, when shock absorber 47A is compressed and the length becomes the shortest).

Meanwhile, as is shown in FIG. 6C, when shutter 49A is driven downward via drive mechanism 34A, opening 51A moves into an opened state, therefore, in the case X-axis stator 81 and X-axis stator 80 draw close together, a part of the tip section of shock absorber 47A can penetrate opening 51A, and X-axis stator 81 and X-axis stator 80 are able to move closer than the state shown in FIG. 6B. In the state where X-axis stator 81 and X-axis stator 80 are closest, it becomes possible to make wafer table WTB and measurement table MTB come into contact (or to be close via a clearance of 300 µm).

The depth of opening 51A can be set so that a gap is formed between shock absorber 47A and the tip edge section (corresponding to the bottom) of opening 51A even in the state where X-axis stator 81 and X-axis stator 80 are closest as is shown in FIG. 6D, or the depth can be set so that shock absorber 47A comes into contact with the tip edge section. Further, in the case when X-axis stator 81 and X-axis stator 80 relatively move in the X-axis direction, the width of the opening can be set in advance according to the amount of the relative movement.

The other stopper 48B also operates similarly.

Referring back to FIG. 2, on the +X edge section of X-axis stator 80, a distance detection sensor 43A and a shock detection sensor 43B are arranged, and on the +X edge section of X-axis stator 81, a plate shaped member 41A that extends in the Y-axis direction is arranged in a projected manner on the +Y side. Further, on the -X edge section of X-axis stator 80, a distance detection sensor 43C and a shock detection sensor 43D are arranged, and on the -X edge section of X-axis stator 81, a plate shaped member 41B that extends in the Y-axis direction is arranged in a projected manner on the +Y side.

Distance detection sensor 43A consists, for example, of a transmission type photosensor (e.g. a transmission type photosensor as in an LED-PTr), and as is shown in FIG. 4, includes a U-shaped fixed member 142, and a light emitting section 144A and a photodetection section 144B, which are arranged on a pair of surfaces of fixed member 142 that face each other. In distance detection sensor 43A, by detecting the output of photodetection section 144B that changes when light emitted from light emitting section 144A is blocked, detection is performed of whether or not there is an object between light emitting section 144A and photodetection section 144B that does not transmit light.

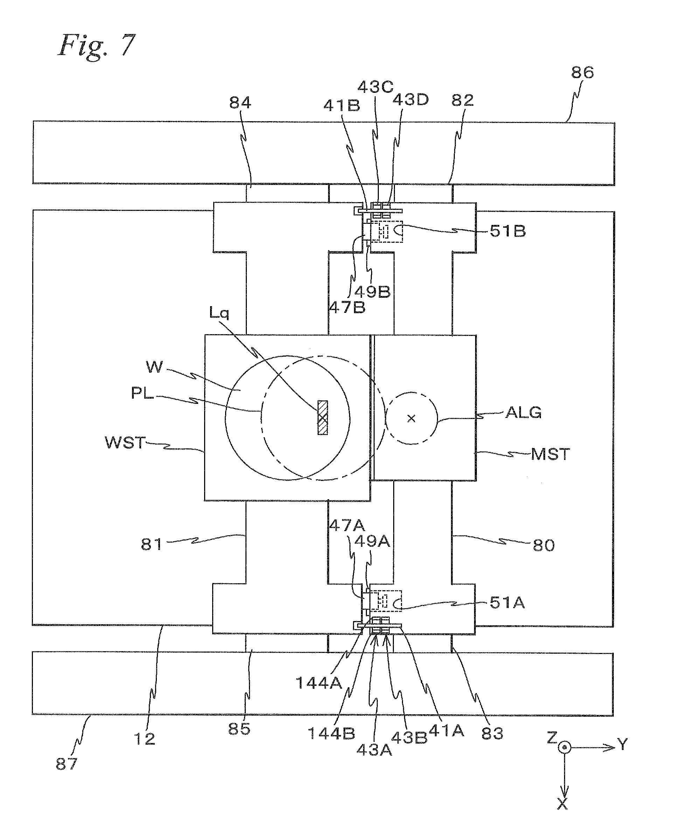

More specifically, with distance detection sensor 43A, in the case X-axis stator 80 and X-axis stator 81 move closer than the state shown in FIG. 4, then plate shaped member 41A enters the space between light emitting section 144A and photodetection section 144B as is shown in FIG. 7. In this case, the lower half section of plate shaped member 41A blocks the light from light emitting section 144A, therefore, the light does not enter photodetection section 144B, which decreases an output current. Accordingly, in main controller 20, by detecting the output current, it becomes possible to detect whether or not the distance between the two movable bodies has fallen under a predetermined distance.

Shock detection sensor 43B includes a U-shaped fixed member 143, and a light emitting section 145A and a photodetection section 145B, which are arranged on a pair of surfaces of fixed member 143 that face each other, and shock detection sensor 43B is a sensor that detects whether or not there is an object between light emitting section 145A and photodetection section 145B that does not transmit light, by detecting the output of photodetection section 145B that changes when light emitted from light emitting section 145A is blocked. In this case, as is shown in FIG. 4, light emitting section 145A is set to a position whose position in the Z-axis direction (height position) is different to that of light emitting section 144A of distance detection sensor 43A previously described, and photodetection section 145B is set to a position whose position in the Z-axis direction (height position) is different to that of photodetection section 144B of distance detection sensor 43A.

With shock detection sensor 43B, in the case X-axis stator 81 and X-axis stator 80 move much closer and at the point when wafer table WTB and measurement table MTB come into contact, the upper half section of plate shaped member 41A is positioned in the space between light emitting section 145A and photodetection section 145B, therefore, the light from light emitting section 145A does not enter photodetection section 145B.

Incidentally, in FIG. 4, plate shaped member 41A is set so that the lower half section is longer (in a more protruded state in the +Y direction) than the upper half section. This is to make the upper half section of plate shaped member 41A be positioned between light emitting section 145A and photodetection section 145B when wafer table WTB and measurement table MTB come into contact. Accordingly, in the case shock detection sensor 43B can be set further on the -Y side, a rectangular plate shaped member can simply be employed.

Incidentally, distance detection sensor 43C and shock detection sensor 43D arranged in the vicinity of the -X edge section are configured similar to distance detection sensor 43A and shock detection sensor 43B arranged in the vicinity of the -X edge section previously described, and plate shaped member 41B is also configured similar to plate shaped member 41A, therefore, description on the details will be omitted.

Referring back to FIG. 1, in exposure apparatus 100 of the embodiment, for a holding member that holds projection unit PU, an off-axis alignment system (hereinafter simply referred to as an 'alignment system') ALG is arranged. As alignment system ALG, for example, a sensor of an FIA (Field Image Alignment) system based on an image-processing method is used. This sensor irradiates a broadband detection beam that does not expose the resist on the wafer on a target mark, picks up the images of the target mark formed on the photodetection surface by the reflection light from the target mark and an index (an index pattern on an index plate arranged within alignment system ALG) with a pick-up device (such as a CCD), and outputs the imaging signals. The imaging signals from alignment system ALG are to be supplied to main controller 20 shown in FIG. 8.

As alignment system ALG, the system is not limited to the FIA system, and as the system it is naturally possible to use an alignment sensor that irradiates a coherent detection light onto the target mark and detects scattered light or diffracted light generated from the target mark, or a sensor that detects two diffracted lights (for example, diffracted lights of the same order or diffracted lights that diffract in the same direction) generated from the target mark by making them interfere with each other, independently, or appropriately combined.

In exposure apparatus 100 of the embodiment, although it is omitted in FIG. 1, a multiple point focal position detection system by an oblique incident method consisting of an irradiation system 90a and a photodetection system 90b (refer to FIG. 8) similar to the one disclosed in, for example, Kokai (Japanese Patent Unexamined Application Publication) No. 6-283403 and the corresponding U.S. Patent No. 5,448,332 or the like, is arranged. In the embodiment, as an example, irradiation system 90a is supported by suspension by the holding member, which holds projection unit PU on the -X side of projection unit PU, and photodetection system 90b is supported by suspension under the holding member on the +X side of projection unit PU. That is, irradiation system 90a and photodetection system 90b, and projection optical system PL are attached to the same member, and the positional relation between the units are constantly maintained. As long as the national laws in designated states (or elected states), on which this international application is applied, permit, the above disclosure of the U.S. Patent is incorporated herein by reference.

FIG. 8 shows the main configuration of a control system in exposure apparatus 100 of the embodiment. The control system is mainly composed of main controller 50, which is made up of a microcomputer (or workstation) that controls the overall operation of the entire apparatus.

Next, details on a parallel processing operation using wafer stage WST and measurement stage MST will be described, referring to FIGS. 2, 7, 9 and the like. During the operation below, main controller 20 performs the open/close operation of each valve in liquid supply unit 5 and liquid recovery unit 6 of liquid immersion unit 32 as is previously described, and the space directly under tip lens 191 of projection optical system PL is constantly filled with the water. However, in the description below, for the sake of simplicity, the description related to the control of liquid supply unit 5 and liquid recovery unit 6 will be omitted.

FIG. 2 shows a state where exposure of wafer W (in this case, for instance, the wafer is to be the last wafer of a lot (one lot consists of 25 or 50 wafers)) on wafer stage WST is performed by the step-and-scan method. At this point, measurement stage MST is waiting at a predetermined waiting position where it does not bump into wafer stage WST. Further, in this case, in order to prevent wafer stage WST and measurement stage MST from becoming closer than the predetermined distance, shutters 49A and 49B are set so that openings 51A and 51B are in a closed state.

The exposure operation above is performed by main controller 20, based on the results of wafer alignment such as Enhanced Global Alignment (EGA) and the latest measurement results of the baseline of alignment system ALG which are performed in advance, by repeatedly performing a movement operation between shots in which wafer stage WST is moved to a scanning starting position (acceleration starting position) for exposure of each of the shot areas on wafer W and a scanning exposure operation in which the pattern formed on reticle R is transferred onto each of the shot areas by the scanning exposure method. The exposure operation described above is performed in a state where the water is held between tip lens 191 and wafer W.

Then, on the wafer W side at the point where exposure of wafer W has been completed, main controller 20 drives shutter 49A and 49B downward via drive mechanisms 34A and 34B, and sets openings 51A and 51B to an open state. After confirming that shutters 49A and 49B are in a fully opened state via open/close sensor 101, main controller 20 controls stage drive system 124 based on measurement values of interferometer system 118 and measurement values of encoder 77B so as to move measurement stage MST (measurement table MTB) to the position shown in FIG. 7. At this point, the -Y side surface of measurement table MTB and the +Y side surface of wafer table WTB are in contact. Of interferometer system 118, measurement values of the interferometer that measures the position of each table in the Y-axis direction can be monitored so that measurement table MTB and wafer table WTB are distanced apart by around 300 µm so that a non-contact state is maintained.

Next, main controller 20 begins an operation of driving both wafer stage WST and measurement stage MST simultaneously in the -Y direction, while maintaining the positional relation between wafer table WT and measurement table MTB in the Y-axis direction.

When wafer stage WST and measurement stage MST are simultaneously moved by main controller 20 in the manner described above, the water that has been held in the space between tip lens 191 of projection unit PU and wafer W sequentially moves over the following areas along with the movement of wafer stage WST and measurement stage MST to the -Y side; wafer W → water repellent plate 28 → measurement table MTB. During the movement above, wafer table WTB and measurement table MTB maintain the positional relation of being in contact with each other.

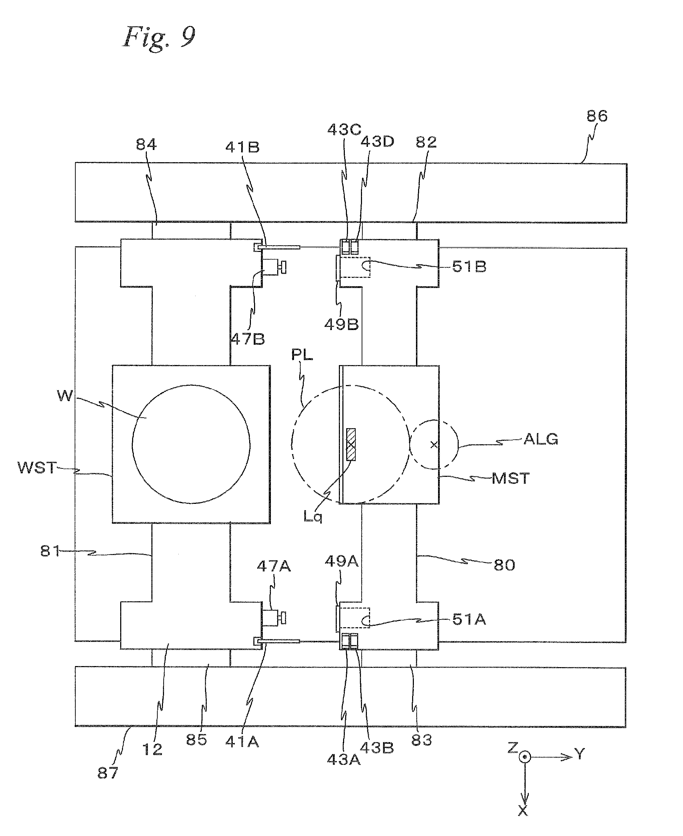

When wafer stage WST and measurement stage MST are simultaneously moved further in the -Y direction by a predetermined distance from the state described above, then the state occurs where water is held in the space between measurement stage MST and tip lens 191, as is shown in FIG. 9.

Next, main controller 20 controls stage drive system 124 while controlling the position of wafer state WST based on the measurement values of interferometer system 118 and encoder 77A so that wafer stage WST moves to a predetermined wafer exchange position and also performs wafer exchange to the first wafer of the next lot, and in parallel with the operation, a predetermined measurement using measurement stage MST is performed as necessary. As such measurement, for instance, baseline measurement of alignment system ALG can be given. More specifically, main controller 20 detects a first fiducial mark in pairs within a fiducial mark area arranged on measurement table MTB and the corresponding reticle alignment marks on the reticle at the same time using reticle alignment systems RAa and RAb previously described, and detects the positional relation between the first fiducial mark in pairs and the corresponding reticle alignment marks. And, at the same time, main controller 20 also detects second fiducial marks within the fiducial mark area using alignment system ALG so as to detect the positional relation between the detection center of alignment system ALG and the second fiducial marks. Then, main controller 20 obtains the distance between the projection center of the reticle pattern by projection optical system PL and the detection center of alignment system ALG, that is, obtains the baseline of alignment system ALG, based on the positional relation between the first fiducial mark in pairs and the corresponding reticle alignment marks and the positional relation between the detection center of alignment system ALG and the second fiducial marks obtained above, and the known positional relation between the first fiducial mark in pairs and the second fiducial marks.

Reticle alignment marks in a plurality of pairs have been formed on the reticle and also the first fiducial mark in a plurality of pairs have been formed on the fiducial mark area corresponding to the reticle alignment marks, and along with measuring the baseline of alignment system ALG described above, by measuring the relative position of at least two pairs of the first fiducial marks and the corresponding reticle alignment marks using reticle alignment systems RAa and RAb while stepping reticle stage RST and measurement stage MST in the Y-axis direction, the so-called reticle alignment is performed.

In this case, mark detection using reticle alignment systems RAa and RAb is performed via projection optical system PL and the water.

Then, at the point where the operations described above on both stages WST and MST have been completed, main controller 20 makes measurement stage MST come into contact with wafer stage WST, and drives measurement stage MST and wafer stage WST within the XY plane while maintaining the state so that wafer stage WST returns to the positioned directly below the projection unit. As is previously described, measurement stage MST and wafer stage WST can move into a non-contact state.

Then, opposite to the operation above, main controller 20 simultaneously drives wafer stage WST and measurement stage MST in the +Y direction while maintaining the positional relation of both stages in the Y-axis direction, and then withdraws measurement stage MST to a predetermined position after wafer stage WST (the wafer) moves to the position under projection optical system PL. At this point, main controller 20 drives shutters 49A and 49B upward via drive mechanisms 34A and 34B so that openings 51A and 51B are set to a closed state.

Then, main controller 20 performs wafer alignment and the exposure operation by the step-and-scan method on the new wafer, and sequentially transfers the reticle pattern onto the plurality of shot areas on the wafer. And hereinafter, the same operation is repeatedly performed.

In the description above, the case has been described where baseline measurement is performed as the measurement operation. However, the present invention is not limited to this, and at least one of an illuminance measurement, uneven illuminance measurement, aerial image measurement, wavefront aberration measurement and the like can be performed using the group of measurement instruments of measurement stage MST while each wafer is being exchanged on the wafer stage WST side, and the measurement results can be reflected to the exposure of wafers that will be performed thereafter. More specifically, for example, based on the measurement results, projection optical system PL can be adjusted using an image forming characteristic correction controller (not shown). Further, the aerial image measurement instrument, uneven illuminance measurement, illuminance monitor, and wavefront aberration measurement instrument described above do not all have to be equipped in the apparatus, and only a part of the instruments can be installed as necessary.

Further, in the description above, alignment to the new wafer is performed after measurement stage MST is withdrawn, however, at least a part of the wafer alignment to the new wafer can be performed before wafer stage WST and measurement stage MST come into contact, and/or in the state where measurement stage MST are in contact.

While the various operations described above are being performed, interferometer system 118 measures the position and speed of wafer table WTB (wafer stage WST) and the position and speed of measurement table MTB (measurement stage MST). Main controller 20 computes the relative speed of both of the stages per each time, and in the case the relative speed that has been computed exceeds a value that is determined in advance (a threshold value), main controller 20 performs control of the speed of both of the stages so that the speed is suppressed and the stage is kept from going out of control or bumping into other members.

As is describe so far in detail, according to exposure apparatus 100 of the embodiment, not only are the two X-axis stators 80 and 81 restrained from moving closer than a predetermined distance by stopper mechanisms 48A and 48B, but the also wafer table WTB (water repellent plate 28) and measurement table MTB are restrained from moving closer than a predetermined distance. Further, by shutters 49A and 49B being withdrawn using drive mechanisms 34A and 34B, the blockings by stopper mechanisms 48A and 48B are released and the two X-axis stators 80 and 81 can move closer to each other than the predetermined distance, and wafer table WTB (water repellent plate 28) and measurement table MTB can also move closer than a predetermined distance.

Especially in the case when a liquid immersion type exposure apparatus is used as the exposure apparatus as in exposure apparatus 100 of the embodiment, the blockings by shock absorbers 49A and 49B are released on transition from a state in which wafer table WTB (or measurement table MTB) is positioned immediately below projection optical system PL to a state in which measurement table MTB (or wafer table WTB) is positioned immediately below projection optical system PL. Therefore, because wafer table WTB (water repellent plate 28) and measurement table MTB can be moved immediately below the projection optical system in a state where wafer table WTB and measurement table MTB are in contact, the following series of operations from (1) to (3) do not have to be performed. That is, the series of operations such as; (1) recovering the water existing on water repellent plate 28 (or measurement table MTB), (2) moving measurement table MTB (or wafer table WTB) immediately under the projection optical system, and (3) supplying the water again, will not be necessary. Accordingly, the exposure accuracy is maintained at a high level, and it also becomes possible to increase the speed of the movement of the two stages, which in turn makes it possible to achieve high throughput.

Further, main controller 20 restricts the speed of at least one of the two stators X-axis stator 80 and X-axis stator 81 (wafer stage WST and measurement stage MST) when the relative speed of the two stators X-axis stator 80 and X-axis stator 81 (the relative speed of wafer table WTB and measurement table MTB) exceeds a predetermined value. Therefore, main controller 20 can prevent the two stators X-axis stator 80 and X-axis stator 81 (wafer stage WST and measurement stage MST) from going out of control in advance, and reduce the possibility of wafer table WTB and measurement table MTB bumping into each other, which as a consequence makes it possible to prevent wafer stage WST and measurement stage MST from being damaged, maintain the drive performance of each of the stages, and maintain the exposure accuracy.

Further, as the stopper mechanisms, because shock absorbers that ease the shock from the Y-axis direction are employed, shock from the other movable body affecting the one movable body can be eased in the case of blocking the movable bodies from coming closer together, which makes it possible to suppress damage or the like of each movable body as much as possible.

Further, in the embodiment, because open/close sensor 101 that detects at least one of an opened state and a closed state of the shutter is included in the embodiment, by moving the two stators X-axis stator 80 and X-axis stator 81 based on the detection results of open/close sensor 101, X-axis stator 80 and X-axis stator 81 can be made to move closer, or shock absorbers 47A and 47B and shutters 49A and 49B can be kept from mechanically interfering when wafer table WTB and measurement table MTB are made to move closer or to come into contact.

Further, in the embodiment, because the apparatus is equipped with not only stopper mechanisms 48A and 48B but also distance detection sensors 43A and 43C, and detects whether or not the two stators X-axis stator 80 and X-axis stator 81 are closer together than the predetermined distance using the sensors, the degree of closeness of wafer table WTB and measurement table MTB can be detected, and even if wafer stage WST and measurement stage MST goes out of control, it is possible t reduce the possibility of the stages bumping into each other.

Furthermore, in the embodiment, because the apparatus is equipped with shock detection sensors 43B and 43D that detects the bumping of the two stators X-axis stator 80 and X-axis stator 81, by performing drive control of the two stators X-axis stator 80 and X-axis stator 81, the influence due to the bumping of wafer table WTB and measurement table MTB can be reduced as much as possible. Further, with shock detection sensors 43B and 43D detecting the bumping of the two stators, it becomes possible to judge the beginning of maintenance or the like quickly and easily.

Further, in the embodiment, because detachable member 29 is arranged on the -Y side edge section of measurement table MTB, detachable member 29 is detached first which makes it possible to keep the damage caused to the table itself as small as possible even if wafer table WTB and measurement table MTB bump into each other.

In the embodiment above, detachable member 29 was arranged on the measurement table MTB side, however, the present invention is not limited to this, and detachable member 29 can be arranged on the +Y side edge section of wafer table WTB.

In the embodiment above, the case has been described where the stopper mechanisms are arranged in X-axis stators 80 and 81, however, the present invention is not limited to this, and the stopper mechanisms can be arranged in wafer table WTB (or) and measurement table MTB.

In the embodiment above, X-axis stators 80 and 81 are kept from moving close together, as well as wafer table WTB (water repellent plate 28) and measurement table MTB, however, it also goes without saying that the other two objects can be kept from moving close together.

Further, in the embodiment above, the stopper mechanisms are arranged in X-axis stators 80 and 81, however, the configuration in which the stopper mechanism is in arranged in only one of the stators can also be employed.

Further, in the embodiment above, the case has been described where the stopper mechanisms are arranged in X-axis stators 80 and 81 so that X-axis stators 80 and 81 are kept from moving close together and wafer table WTB (water repellent plate 28) and measurement table MTB are kept from coming into contact. The present invention, however, is not limited to this, and the stopper mechanism can be arranged in at least one of the other two objects. For example, the stopper mechanism can be arranged in at least one of wafer table WTB and measurement table MTB, and wafer table WTB (water repellent plate 28) and measurement table MTB can be kept from moving close together. Further, the stopper mechanism can be arranged in at least one of wafer table WTB and measurement table MTB so that X-axis stators 80 and 81 are kept from moving close together, or the other two objects can be kept from moving close together.

Further, in the description above, the blocking function of stopper mechanisms 48A and 48B are released around the time when wafer exchange is performed on wafer stage WST, however, the present invention is not limited to this, and it goes without saying that the blocking function can be released when necessary.

In the embodiment above, the case has been described where stage unit 50 is equipped with wafer stage WST and measurement stage MST, however, the present invention is not limited to this, and the stages can both be a wafer stage. In this case, while exposure operation is being performed on one of the stages, wafer exchange and measurement such as alignment can be performed on the other stage, which holds expectations for improvement in the throughput.

In the embodiment above, shock absorbers were employed as stopper mechanisms, however, the present invention is not limited to this, and various shock absorbers other than shock absorbers (e.g. air dampers) can be used as long as the unit can ease the shock from the Y-axis direction. Further, the stopper mechanism is not limited to shock absorbers, and a stopper mechanism that does not have any shock-absorbing operations can be employed.

In the embodiment above, the shock absorbers were arranged on the X-axis stator 81 side and the shutters for opening/closing the openings formed in X-stator 80 were arranged in X-axis stator 80, however, the present invention is not limited to this, and the shock absorbers can be arranged on the X-axis stator 80 side and the openings can be formed in X-axis stator 81 as well as the shutters.

Further, in the embodiment above, the shutters were driven in the Z-axis direction, however, the present invention is not limited to this, and a configuration in which the shutters move in the X-axis direction can be employed, or a configuration in which a lid-shaped member slightly smaller than the opening is movable in the Y-axis direction inside the opening can be employed.

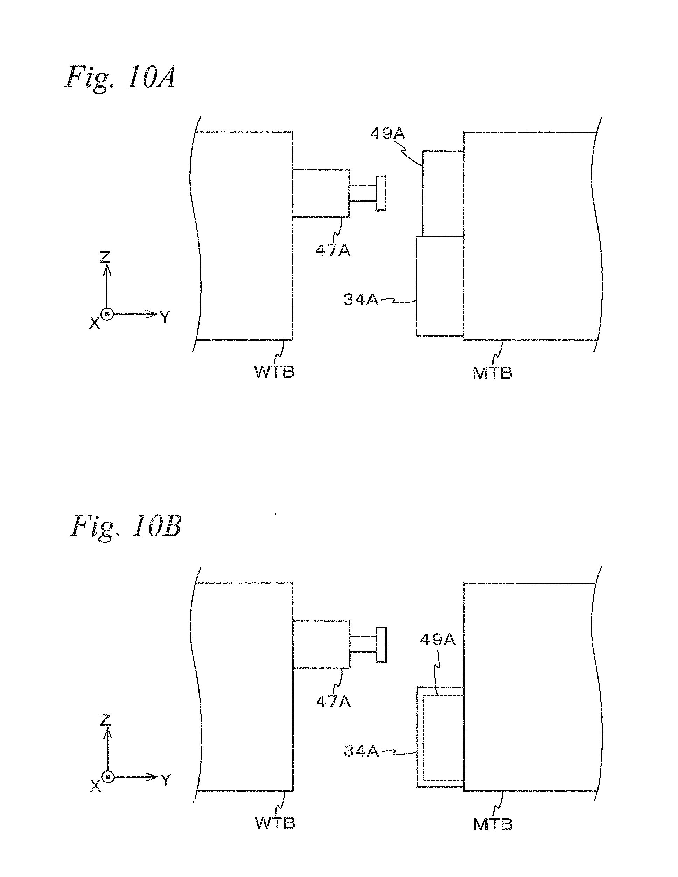

In the embodiment above, the openings were arranged in X-axis stator 80, however, the present invention is not limited to this, and wafer table WTB (water repellent plate 28) and measurement table MTB can be blocked from coming into contact or the blocking can be released according to shock absorber 47A by arranging no openings as is shown in FIG. 10A and configuring shutter 49A with a thick member, and changing the state of shutter 49A from the state shown in FIG. 10A to the state shown in FIG. 10B via drive mechanism 34A that vertically moves shutter 49A.

In the embodiment above, the combination of shock absorbers and shutters fixed to one of the stators, X-axis stator 81 was employed, however, the present invention is not limited to this, and as is shown in FIG. 11A, a configuration in which the shock absorbers can move in the Y-axis direction can be employed. According to the configuration in FIG. 11A, shock absorber 47A is to be driven in the Y-axis direction by a drive mechanism 34' consisting of an air cylinder along a guide 45 arranged on X-axis stator 81. Further, at the position facing shock absorber 47A of X-axis stator 80, a plate member 49' is arranged.

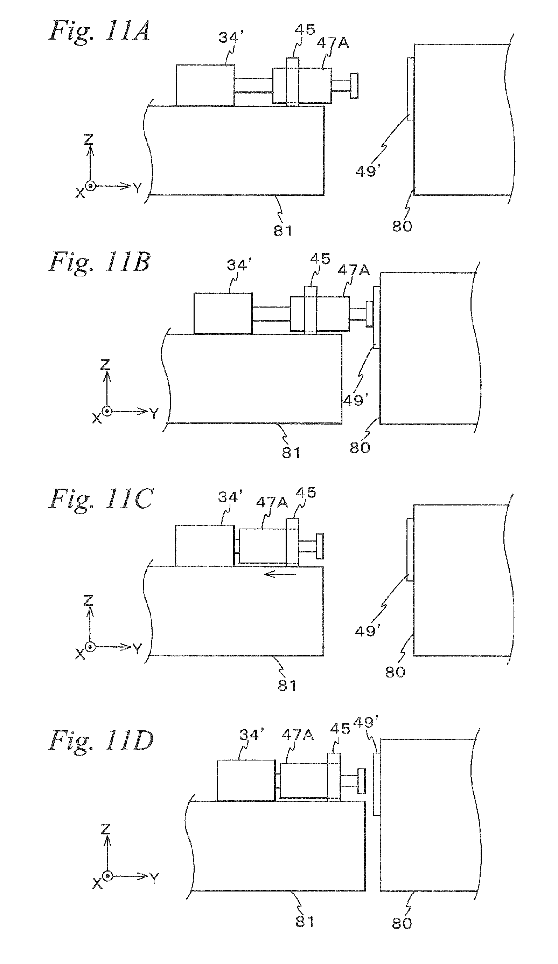

In this case, shock absorber 47A is arranged on the +Y side as is shown in FIG. 11A, and in a state where shock absorber 47 protrudes further on the +Y side than X-axis stator 81, even if both X-axis stators 81 and 80 try to move closer together, X-axis stators 81 and 80 are made so that X-axis stators 81 and 80 cannot move closer than a predetermined distance due to shock absorber 47A and plate member 49 coming into contact, as is shown in FIG. 11B. That is, even in the case if at least one of X-axis stators 81 and 80 go out of control, it becomes possible to avoid wafer table WTB (water repellent plate 28) and measurement table MTB from coming into contact.

Meanwhile, in the case shock absorber 47A is moved to the -Y side by drive mechanism 34' as is shown in FIG. 11C, since shock absorber 47A and plate member 49 do not come into contact as is shown in FIG. 11D, it becomes possible to move X-axis stators 81 and 80 so that they are closest to each other (that it, to make wafer table WTB (water repellent plate 28) and measurement table MTB come into contact or to be positioned closest to each other).

In the modified example above, it is preferable to arrange a sensor that detects at least one of whether the position of shock absorber 47A is at the position shown in FIG. 11A or in the state shown in FIG. 11C.

In the modified example above (FIGS. 11A to 11D), plate member 49 arranged in X-axis stator 80 does not have to be arranged. Further, shock absorber 47A and drive mechanism 34' can be arranged on the X-axis stator 80 side.

As drive mechanisms 34A and 34B for driving shutter 49A in the embodiment above and drive mechanism 34' for driving shock absorber 47A in the modified example above, air cylinders were employed, however, the present invention is not limited to this, and various types of drive mechanisms such as a drive mechanism by a ball screw method, a voice coil motor, a linear motor or the like can be employed.

Further, in the embodiment described above, an interferometer system is used for obtaining positional information of wafer table WTB and measurement table MTB, however, instead of the interferometer system, other measurement systems such as an encoder can also be used.

Further, in the embodiment above, the case has been described where a transmission type photosensor was employed as the distance detection sensor and the shock detection sensor, however, the present invention is not limited to this, and for example, in the case of employing a photosensor, a reflective type photosensor, a split type photosensor or the like can be used. Further, the sensor is not limited to a photosensor, and it is also possible to use a line sensor or a capacitance sensor. Further, as a third and a fourth detection unit, measurement units that directly measure the distance between the two movable bodies can be used.

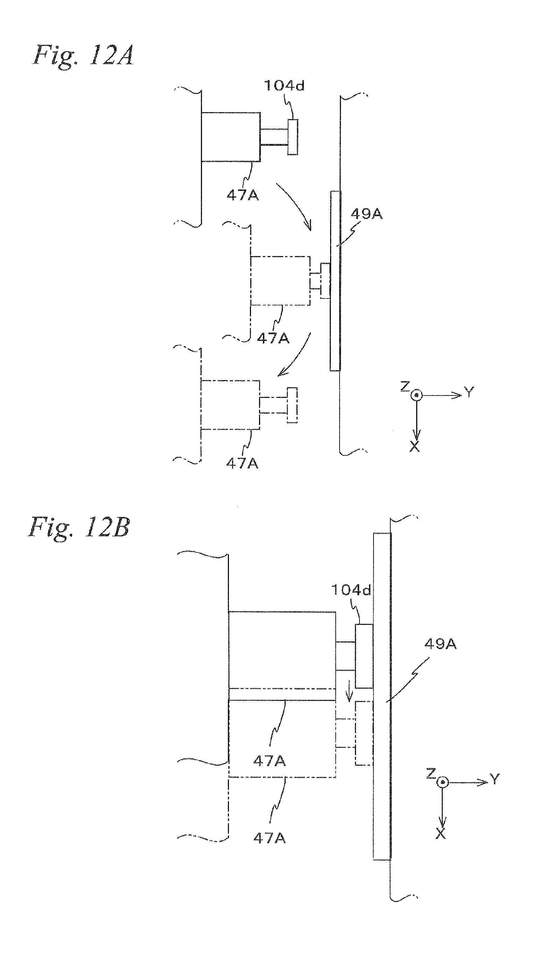

Further, in the embodiment described above, in the case shutter 49A (49B) of stopper mechanism 48A (48B) is in a closed state, although X-axis stators 81 and 80 (wafer table WTB and measurement table MTB) are kept from moving closer than a predetermined distance in the Y-axis direction, X-axis stators 81 and 80 (wafer table WTB and measurement table MTB) can each move relatively in the X-axis direction and the Z-axis direction, even if head section 104d of shock absorber 47A (47B) and shutter 49A (49B) come into contact. For example, when head section 104d of shock absorber 47A and shutter 49A come into contact as is shown in FIG. 12A while X-axis stators 81 and 80 (wafer table WTB and measurement table MTB) are each moving in the X-axis direction, X-axis stators 81 and 80 (wafer table WTB and measurement table MTB) can move in the X-axis direction while restricting X-axis stators 81 and 80 (wafer table WTB and measurement table MTB) from moving closer in the Y-axis direction. In this case, in order to avoid the influence due to friction between head section 104d and shutter 49A, it is preferable to apply surface processing such as coating each of the surfaces of head section 104d and shutter 49A with Teflon (trademark) or the like so that the surfaces become smooth. By this processing, shutter 49A and head section 104d can both move sliding smoothly over each other while shutter 49A and head section 104d maintain the contact state as is shown in FIG. 12B. Because the movement in the X-axis direction is allowed in the manner described above even if shutter 49A and head section 104d are in contact, X-axis stators 81 and 80 (wafer table WTB and measurement table MTB) can be relatively moved in the X-axis direction without being affected by shutter 49A and head section 104d being in contact. Instead of applying the surface processing, the connecting section of head section 104d with shutter 49A can be a rotatable spherical shape. FIGS. 12A and 12B show views of X-axis stators 81 and 80 (wafer table WTB and measurement table MTB) being relatively moved in the X-axis direction, however, the relative movement is similar for the Z-axis direction as well.

In the embodiment above, the case has been described where the exposure apparatus was a liquid immersion type exposure apparatus, however, the present invention is not limited to this, and it is also possible to apply the present invention to an exposure apparatus, to a dry type exposure apparatus that performs exposure of a wafer without going through the liquid (water). In this case, even if the two stages go out of control on parallel operation such as the exposure operation, the alignment operation and the like, both of the stages can be kept from bumping into each other, and in the case the two stages have to come close together, by releasing the stopper mechanisms, the two stages can move closer without the stopper mechanisms in the way.

In the embodiment above, pure water (water) is used as the liquid, however, as a matter of course, the present invention is not limited to this. As the liquid, a liquid that is chemically stable, having high transmittance to illumination light IL and safe to use, such as a fluorine containing inert liquid may be used. As such as a fluorine-containing inert liquid, for example, Fluorinert (the brand name of 3M United States) can be used. The fluorine-containing inert liquid is also excellent from the point of cooling effect. Further, as the liquid, a liquid which has high transmittance to illumination light IL and a refractive index as high as possible, and furthermore, a liquid which is stable against the projection optical system and the photoresist coated on the surface of the wafer (for example, cederwood oil or the like) can also be used. Further, in the case the F₂ laser is used as the light source, fomblin oil may be used as the fluorine containing liquid.

Further, in the embodiment above, the liquid that has been recovered may be reused. In this case, it is desirable to arrange a filter in the liquid recovery unit, in the recovery pipes, or the like for removing impurities from the liquid that has been recovered.

Further, in the embodiment above, the case has been described where the present invention is applied to a scanning exposure apparatus by the step-and-scan method or the like. It is a matter of course, that the present invention is not limited to this. More specifically, the present invention can also be applied to a projection exposure apparatus by the step-and-repeat method, and further to an exposure apparatus by the step-and-stitch method, an exposure apparatus by the proximity method and the like.

The usage of the exposure apparatus to which the present invention is applied is not limited to the exposure apparatus used for manufacturing semiconductor devices. For example, the present invention can be widely applied to an exposure apparatus for manufacturing liquid crystal displays which transfers a liquid crystal display device pattern onto a square shaped glass plate, and to an exposure apparatus for manufacturing organic EL, thin-film magnetic heads, imaging devices (such as CCDs), micromachines, DNA chips or the like. Further, the present invention can also be suitably applied to an exposure apparatus that transfers a circuit pattern onto a glass substrate or a silicon wafer not only when producing microdevices such as semiconductors, but also when producing a reticle or a mask used in exposure apparatus such as an optical exposure apparatus, an EUV exposure apparatus, an X-ray exposure apparatus, or an electron beam exposure apparatus.

Further, the light source of the exposure apparatus in the embodiment above is not limited to the ArF excimer laser, and a pulsed laser light source such as a KrF excimer laser (output wavelength: 248 nm), an F₂ laser (output wavelength: 157 nm), an Ar₂ laser (output wavelength: 126 nm), or an Kr₂ laser (output wavelength: 146 nm), or an ultra high-pressure mercury lamp that generates a bright line such as the g-line (wavelength 436 nm) or the i-line (wavelength 365 nm) can also be used as the light source. Further, a harmonic wave may also be used that is obtained by amplifying a single-wavelength laser beam in the infrared or visible range emitted by a DFB semiconductor laser or fiber laser, with a fiber amplifier doped with, for example, erbium (or both erbium and ytteribium), and by converting the wavelength into ultraviolet light using a nonlinear optical crystal. Further, the projection optical system is not limited to a reduction system, and the system may be either an equal magnifying system or a magnifying system.

Further, in each of the embodiments above, illumination light IL of the exposure apparatus is not limited the light having the wavelength equal to or greater than 100nm, and it is needless to say that the light having the wavelength less than 100nm may be used. For example, in recent years, in order to expose a pattern equal to or less than 70nm, an EUV exposure apparatus that uses an SOR or a plasma laser as a light source to generate an EUV (Extreme Ultraviolet) light in a soft X-ray range (such as a wavelength range from 5 to 15 nm), and also uses a total reflection reduction optical system designed under the exposure wavelength (such as 13.5nm) and the reflective type mask has been developed. In the EUV exposure apparatus, the arrangement in which scanning exposure is performed by synchronously scanning a mask and a wafer using a circular arc illumination can be considered.

### - Device Manufacturing Method

Next, an embodiment will be described of a device manufacturing method that uses the exposure apparatus described above in the lithography step.

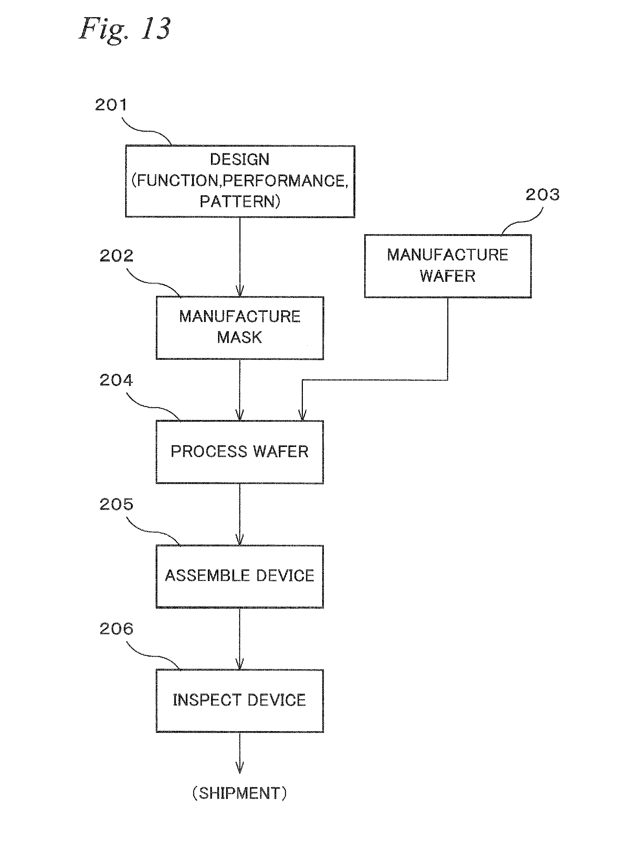

FIG. 13 shows the flowchart of an example when manufacturing a device (a semiconductor chip such as an IC or an LSI, a liquid crystal panel, a CCD, a thin-film magnetic head, a micromachine, and the like). As shown in FIG. 13, in step 201 (design step), function and performance design of device (circuit design of semiconductor device, for example) is performed first, and pattern design to realize the function is performed. Then, in step 202 (mask manufacturing step), a mask on which the designed circuit pattern is formed is manufactured. Meanwhile, in step 203 (wafer manufacturing step), a wafer is manufactured using materials such as silicon.

Next, in step 204 (wafer processing step), the actual circuit and the like are formed on the wafer by lithography or the like in a manner that will be described later, using the mask and the wafer prepared in steps 201 to 203. Then, in step 205 (device assembly step), device assembly is performed using the wafer processed in step 204. Step 205 includes processes such as the dicing process, the bonding process, and the packaging process (chip encapsulation), and the like when necessary.

Finally, in step 206 (inspection step), tests on operation, durability, and the like are performed on the devices made in step 205. After these steps, the devices are completed and shipped out.

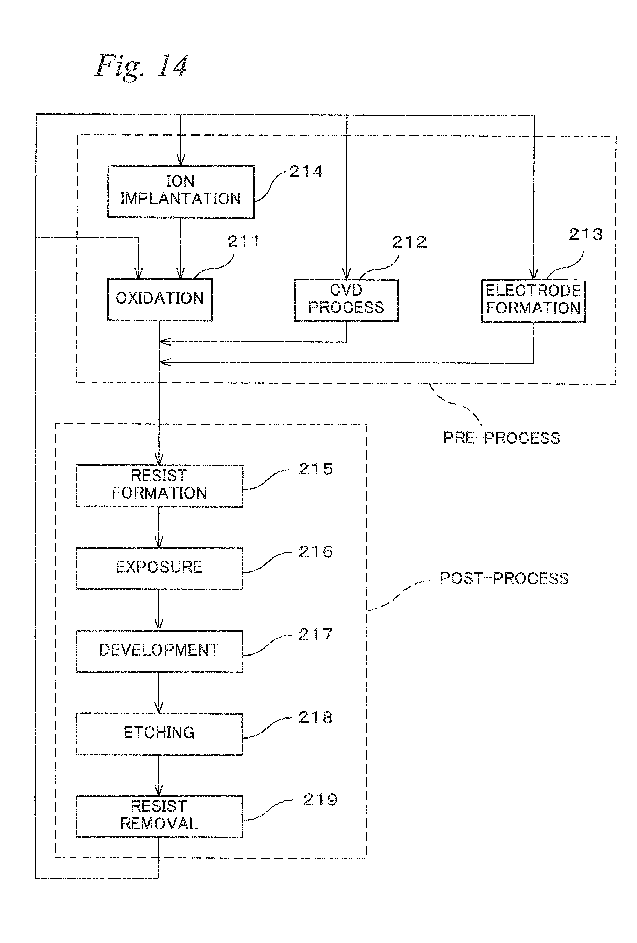

FIG. 14 is a flow chart showing a detailed example of step 204 described above. Referring to FIG. 14, in step 211 (oxidation step), the surface of wafer is oxidized. In step 212 (CDV step), an insulating film is formed on the wafer surface. In step 213 (electrode formation step), an electrode is formed on the wafer by deposition. In step 214 (ion implantation step), ions are implanted into the wafer. Each of the above steps 211 to 214 constitutes the pre-process in each step of wafer processing, and the necessary processing is chosen and is executed at each stage.

When the above-described pre-process ends in each stage of wafer processing, post-process is executed as follows. In the post-process, first in step 215 (resist formation step), a photosensitive agent is coated on the wafer. Then, in step 216 (exposure step), the circuit pattern of the mask is transferred onto the wafer by the lithography system (exposure apparatus) and the exposure method of the embodiment above. Next, in step 217 (development step), the exposed wafer is developed, and in step 218 (etching step), an exposed member of an area other than the area where resist remains is removed by etching. Then, in step 219 (resist removing step), when etching is completed, the resist that is no longer necessary is removed.

By repeatedly performing the pre-process and the post-process, multiple circuit patterns are formed on the wafer.

When the device manufacturing method of the embodiment described so far is used, because the exposure apparatus in the embodiment above is used in the exposure step (step 216), exposure with high throughput can be performed while maintaining a high overlay accuracy. Accordingly, productivity of high integration microdevices on which fine patterns are formed can be improved.

As it has been described, the movable body unit of the present invention is suitable for driving two movable bodies that can be moved independently in a predetermined uniaxial direction. Further, the exposure apparatus and the device manufacturing method of the present invention are suitable for producing electronic devices such as semiconductors, liquid crystal display devices and the like.

## Claims

1. A movable body system that has two movable bodies that can be moved independently in a predetermined uniaxial direction, the system comprising:
a stopper mechanism that blocks the two movable bodies from moving closer to each other than a predetermined distance;
a release mechanism that releases the blocking by the stopper mechanism so that the two movable bodies are allowed to move closer than the predetermined distance.

2. The movable body system of Claim 1 wherein
the stopper mechanism includes a shock absorber that eases shock from the uniaxial direction, arranged in one of the movable bodies.

3. The movable body system of Claim 2 wherein
the stopper mechanism further includes
a plate shaped member that is arranged at a position facing the shock absorber of the other movable body.

4. The movable body system of Claim 2 wherein
the release mechanism includes a first change mechanism that changes the position of the shock absorber from a first position where the two movable bodies are blocked from moving closer to each other than a predetermined distance to a second position where the two movable bodies are allowed to move closer.

5. The movable body system of Claim 4, the system further comprising:
a first detection unit that detects the shock absorber located in at least one of the first position and the second position.

6. The movable body system of Claim 1 wherein the stopper mechanism comprises:
a shock absorber that eases shock from the uniaxial direction, arranged in one of the movable bodies; and
a movable member arranged in the other movable body that can come into contact with the shock absorber, whereby
the release mechanism includes a second change mechanism that changes the position of the movable member from a first position where the movable member can come into contact with the shock absorber to a second position where the movable member cannot come into contact with the shock absorber.

7. The movable body system of Claim 6, the system further comprising:
a second detection unit that detects the movable member located in at least one of the first position and the second position.

8. The movable body system of Claim 6 wherein
an opening in which at least a part of a tip section of the shock absorber can enter is formed in the other movable body,
the movable member is a shutter that opens and closes the opening, whereby
the release mechanism changes the shutter from a closed state to an open state.

9. The movable body system of Claim 1 wherein each of the movable bodies comprises:
a first object that can be moved in the uniaxial direction whose longitudinal direction is a direction of another axis orthogonal to the uniaxial direction;
a second object that can be moved in the direction of another axis along the first object; and
a table that connects to the second object.

10. The movable body system of Claim 1, the system further comprising:
a third detection unit that detects distance information of the two movable bodies.

11. The movable body system of Claim 10 wherein
the third detection unit detects whether or not the two movable bodies have moved closer to each other than a predetermined distance.

12. The movable body system of Claim 11, the system further comprising:
a measurement system that measures positional information of each of the two movable bodies in the uniaxial direction separately from the third detection unit.

13. The movable body system of Claim 1, the system further comprising:
a fourth detection unit that detects bumping of the two movable bodies.

14. The movable body system of Claim 1 wherein
to at least a part of the two movable bodies, a detachable member is fixed that can be detached according to the bumping of the two movable bodies.

15. The movable body system of Claim 1 wherein
the release mechanism releases the blocking by the stopper mechanism when the two movable bodies are to move closer than the predetermined distance.

16. The movable body system of Claim 1 wherein
the two movable bodies can move while maintaining a state in which the two movable bodies are in contact or a predetermined state in which the two movable bodies are closer than a predetermined distance.

17. The movable body system of Claim 6 wherein
on a section of the movable member where the shock absorber can come into contact, surface treatment is applied that reduces influence of friction occurring between the movable member and the shock absorber.

18. The movable body system of Claim 6 wherein
a section of the shock absorber where the movable member can come into contact is a rotatable spherical shape.

19. An exposure apparatus that exposes a substrate and forms a pattern on the substrate, the apparatus comprising:
a movable body system according to any one of Claims 1 to 18 that holds the substrate with at least one of the two movable bodies; and
a control unit that controls the operation of the release mechanism.

20. The exposure apparatus of Claim 19 wherein
the control unit limits the speed of at least one of the two movable bodies when a relative speed of the two movable bodies exceed a predetermined value.

21. An exposure apparatus that supplies liquid in the space between an optical system and a substrate and exposes the substrate with an energy beam via the optical system and the liquid, the apparatus comprising:
the movable body system in any one of Claims 1 to 18 in which liquid immersion feasible areas where the liquid can be held are formed in the space between each of the two movable bodies and the optical system, and the substrate is also held in at least one of the two movable bodies; and
a control unit that controls the operation of the two movable bodies while maintaining a state in which the two movable bodies are in contact or a predetermined state in which the two movable bodies are closer than a predetermined distance, so as to move the liquid from the liquid immersion feasible area of one of the movable bodies to the liquid immersion feasible area of the other movable body.

22. The exposure apparatus of Claim 21 wherein
one of the movable bodies has a substrate table that holds the substrate, and
the other movable body has a measurement table on which a measurement section used for predetermined measurement is arranged.

23. The exposure apparatus of Claim 21 wherein
the control unit limits the speed of at least one of the two movable bodies when a relative speed of the two movable bodies exceed a predetermined value.

24. A movable body system, comprising:
two movable bodies that can move independently in a predetermined uniaxial direction;
a change unit that can change an approachable distance between the two movable bodies in the predetermined uniaxial direction among a plurality of distances which are set in advance.

25. The movable body system of Claim 24 wherein
the change unit includes a stopper mechanism that blocks the two movable bodies from moving closer to each other, and
the plurality of distances which are set in advance include a first distance in which the stopper mechanism performs the blocking.

26. The movable body system of Claim 25 wherein
the change unit includes a release mechanism that releases the blocking of the stopper mechanism, and
the plurality of distances which are set in advance include a second distance which can be achieved in a state where the blocking of the stopper mechanism is released.

27. The movable body system of Claim 26 wherein
the two movable bodies are moved closer to the second distance by moving at least one of the two movable bodies, based on results of detecting the position of at least one of the two movable bodies.

28. An exposure apparatus that exposes a substrate and forms a pattern on the substrate, the apparatus comprising:
a movable body system in any one of Claims 24 to 27 that holds the substrate in at least one of the two movable bodies; and
a control unit that controls the operation of the change unit.

29. A device manufacturing method including a lithography process wherein
in the lithography process, a device pattern is transferred onto the substrate using the exposure apparatus of Claim 19.

30. A device manufacturing method including a lithography process wherein
in the lithography process, a device pattern is transferred onto the substrate using the exposure apparatus of Claim 21.

31. A device manufacturing method including a lithography process wherein
in the lithography process, a device pattern is transferred onto the substrate using the exposure apparatus of Claim 28.
